# EUROPEAN PATENT SPECIFICATION

(11) **EP 4 133 537 B1**
(45) Date of publication and mention of the grant of the patent: **16.10.2024**
(21) Application number: 21785195.5
(22) Date of filing: 26.03.2021
(51) Int. Cl.: H01L 27/15, H01L 33/00, H01L 33/02, H01L 33/38

(54) **LIGHT EMITTING DIODE STRUCTURE AND METHOD FOR MANUFACTURING THE SAME**
LEUCHTDIODENSTRUKTUR UND VERFAHREN ZU IHRER HERSTELLUNG
STRUCTURE DE DIODES ÉLECTROLUMINESCENTES ET SON PROCÉDÉ DE FABRICATION

(30) Priority: 09.04.2020 US 202063007831 P; 17.02.2021 US 202117177827
(43) Date of publication of application: 15.02.2023
(73) Proprietor: Raysolve Optoelectronics (Suzhou) Co., Ltd., Suzhou, Jiangsu 215000 (CN)
(72) Inventor: CHONG, Wing Cheung, Suzhou, Jiangsu 215000 (CN)
(74) Representative: Murgitroyd & Company
(86) International application number: PCT/CN2021/083173
(87) International publication number: WO 2021/203986

(56) References cited:
- CN-A- 101 908 534
- CN-A- 107 170 773
- CN-A- 110 957 399
- US-A1- 2009 242 910
- US-A1- 2011 263 054
- US-A1- 2020 083 402

## Description

### TECHNICAL FIELD

The present disclosure relates to a light emitting diode (LED) structure and a method for manufacturing the LED structure, and more particularly, to a LED structure with a plurality of LED units surrounded by an isolation layer and the method for manufacturing the same.

### BACKGROUND

In the recent years, LEDs have become popular in lighting applications. As light sources, LEDs have many advantages including higher light efficiency, lower energy consumption, longer lifetime, smaller size, and faster switching.

Displays having micro-scale LEDs are known as micro-LED. Micro-LED displays have arrays of micro-LEDs forming the individual pixel elements. A pixel may be a minute area of illumination on a display screen, one of many from which an image is composed. In other words, pixels may be small discrete elements that together constitute an image as on a display. Pixels are normally arranged in a two-dimensional (2D) matrix, and are represented using dots, squares, rectangles, or other shapes. Pixels may be the basic building blocks of a display or digital image and with geometric coordinates.

When manufacturing the micro-LEDs, an etching process, such as a dry etching or a wet etching process, is frequently used to electrically isolate individual micro-LEDs. In order to yield a plurality of fully isolated functional micro-LED mesas, the conventional process typically etches away the continuous functional epitaxy layer completely. However, when transferring, or after transferring, the conventional micro-LED mesas to a substrate, such as a driving circuit substrate, the fully isolated functional micro-LED mesas may easily peel off from the substrate because the adhesion of the micro-LED mesas is weak. The problem is even more significant when the micro-LED mesas become even smaller. Furthermore, during the convention etching process to isolate the micro-LED mesas, the sidewalls of the micro-LED mesas may be damaged and impact the optical and electrical properties of the LED structure.

Patent document No. US20200083402A1 discloses techniques for wafer-to-wafer bonding for manufacturing light emitting diodes (LEDs). A method of manufacturing LEDs includes etching a semiconductor material to form a plurality of adjacent mesa shapes. The semiconductor material includes one or more epitaxial layers. The method also includes forming a passivation layer within gaps between the adjacent mesa shapes and bonding a base wafer to a first surface of the semiconductor material.

Patent document No. US20110263054A1 discloses an improved method of creating LEDs. Rather than using a dielectric coating to separate the bond pads from the top surface of the LED, this region of the LED is implanted with ions to increase its resistivity to minimize current flow therethrough. A plurality of LEDs are produced on a single substrate by implanting ions in the regions between the LEDs and then etching a trench, where the trench is narrower than the implanted regions and positioned within these regions. This results in a trench where both sides have current confinement capabilities to reduce leakage.

Patent document No. US20090242910A1 discloses a light emitting device, including: a first semiconductor region; a second semiconductor region and third semiconductor region which are provided in the first semiconductor region; a first semiconductor light emitting element of which first electrode is electrically connected to a main surface of the second semiconductor region; a second semiconductor light emitting element of which third electrode is electrically connected to a main surface of the third semiconductor region; and a conductor which electrically connects the second electrode of the first semiconductor light emitting element and the third semiconductor region, and which electrically connects the second electrode and the third electrode through the third semiconductor region. In the light emitting device, the semiconductor light emitting elements are connected in series, and are directly connected to a power source.

Embodiments of the disclosure address the above problems by providing a LED structure with a plurality of LED units surrounded by an isolation layer and the method for manufacturing the same, and therefore the drawbacks of using etching process can be avoided.

### SUMMARY

Embodiments of the LED structure and method for forming the LED structure are disclosed herein.

In one example, a LED structure is disclosed. The LED structure includes a substrate, a bonding layer, a first doping type semiconductor layer, a multiple quantum well (MQW) layer, a second doping type semiconductor layer, a passivation layer and an electrode layer. The bonding layer is formed on the substrate, and the first doping type semiconductor layer is formed on the bonding layer. The MQW layer is formed on the first doping type semiconductor layer, and the second doping type semiconductor layer is formed on the MQW layer. The second doping type semiconductor layer includes an isolation material made through implantation, and the passivation layer is formed on the second doping type semiconductor layer. The electrode layer is formed on the passivation layer in contact with a portion of the second doping type semiconductor layer through a first opening on the passivation layer, the isolation material divides the second doping type semiconductor layer into a plurality of LED mesas, and the plurality of LED mesas correspond to a plurality of LED units, respectively, and the LED structure further includes: a plurality of contacts of a driving circuit formed in the substrate, each contact is located at an interspace of adjacent LED mesas, the electrode layer electrically connects the second doping type semiconductor layer and the contact through the first opening and a second opening on each contact, and each LED unit is individually driven by a corresponding contact of the driving circuit, and the plurality of LED mesas include a first LED mesa and a second LED mesa adjacent to the first LED mesa, and the MQW layer, the first doping type semiconductor layer and the bonding layer beneath the first LED mesa horizontally extend to the MQW layer, the first doping type semiconductor layer and the bonding layer beneath the second LED mesa.

In another example, the isolation material includes an ion-implanted material.

In another example, the ion-implanted material includes hydrogen, helium, nitrogen, oxygen, fluorine, magnesium, silicon, or argon ion implanted material.

In another example, each LED unit includes: the bonding layer formed on the substrate; the first doping type semiconductor layer formed on the bonding layer; the MQW layer formed on the first doping type semiconductor layer; and the second doping type semiconductor layer formed on the MQW layer, the plurality of LED units includes a first LED unit and a second LED unit adjacent to the first LED unit, and the second doping type semiconductor layer of the first LED unit is electrically isolated with the second doping type semiconductor layer of the second LED unit by the isolation material.

In another example, a method for manufacturing a LED structure is disclosed. The method includes: forming a semiconductor layer on a first substrate, the semiconductor layer comprising a first doping type semiconductor layer, a multiple quantum well (MQW) layer on the first doping type semiconductor layer, and a second doping type semiconductor layer on the MQW layer; performing an implantation operation to form an ion-implanted material in the second doping type semiconductor layer, to divide the second doping type semiconductor layer into a plurality of LED mesas, where each LED mesa is electrically isolated by the ion-implanted material; performing a first etching operation to remove at least a portion of the ion-implanted material, a portion of the MQW layer, a portion of the first doping type semiconductor layer and a portion of the bonding layer to expose a plurality of contact of a driving circuit formed in the first substrate; forming a passivation layer on the second doping type semiconductor layer; forming a first opening on the passivation layer exposing a portion of the second doping type semiconductor layer and a second opening on the passivation layer exposing the contact; and forming an electrode layer on the passivation layer covering the first opening and the second opening, and each contact is located at an interspace of adjacent LED mesas, and the electrode layer electrically connects the second doping type semiconductor layer and the contact through the first opening and the second opening on each contact, and the plurality of LED mesas include a first LED mesa and a second LED mesa adjacent to the first LED mesa, and the MQW layer, the first doping type semiconductor layer and the bonding layer beneath the first LED mesa horizontally extend to the MQW layer, the first doping type semiconductor layer and the bonding layer beneath the second LED mesa, and the plurality of LED mesas correspond to a plurality of LED units, respectively, and each LED unit is individually driven by a corresponding contact of the driving circuit.

In another example, the implantation operation is performed with an implantation energy between about 10 keV and about 300 keV.

In another example, forming the semiconductor layer on the first substrate, includes: forming a driving circuit in the first substrate; forming the semiconductor layer on a second substrate; bonding the semiconductor layer onto the first substrate through a bonding layer; and removing the second substrate.

### BRIEF DESCRIPTION OF DRAWINGS

The accompanying drawings, which are incorporated herein and form a part of the specification, illustrate implementations of the present disclosure and, together with the description, further serve to explain the present disclosure and to enable a person skilled in the pertinent art to make and use the present disclosure.
FIG. 1 illustrates a top view of an exemplary LED structure, according to some implementations of the present disclosure.
FIG. 2 illustrates a cross-section view of an exemplary LED structure, according to some implementations of the present disclosure.
FIG. 3 illustrates another cross-section view of an exemplary LED structure, according to some implementations of the present disclosure.
FIG. 4 illustrates another top view of an exemplary LED structure, according to some implementations of the present disclosure.
FIG. 5 illustrates a top view of another exemplary LED structure, according to some implementations of the present disclosure.
FIGs. 6A-6H illustrate cross sections of an exemplary LED structure at different stages of a manufacturing process, according to some implementations of the present disclosure.
FIGs. 7A-7D illustrate top views of an exemplary LED structure at different stages of a manufacturing process, according to some implementations of the present disclosure.
FIG. 8 is a flowchart of an exemplary method for manufacturing a LED structure, according to some implementations of the present disclosure.

Implementations of the present disclosure will be described with reference to the accompanying drawings.

### DETAILED DESCRIPTION

Although specific configurations and arrangements are discussed, it should be understood that this is done for illustrative purposes only. As such, other configurations and arrangements can be used without departing from the scope of the invention as defined by the claims.

Functional and structural features as described in the present disclosures can be combined, adjusted, and modified with one another and in ways not specifically depicted in the drawings, such that these combinations, adjustments, and modifications are within the scope of the invention as defined by the claims.

In general, terminology may be understood at least in part from usage in context. For example, the term "one or more" as used herein, depending at least in part upon context, may be used to describe any feature, structure, or characteristic in a singular sense or may be used to describe combinations of features, structures or characteristics in a plural sense. Similarly, terms, such as "a," "an, " or "the, " again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

It should be readily understood that the meaning of "on, " "above, " and "over" in the present disclosure should be interpreted in the broadest manner such that "on" not only means "directly on" something but also includes the meaning of "on" something with an intermediate feature or a layer therebetween, and that "above" or "over" not only means the meaning of "above" or "over" something but can also include the meaning it is "above" or "over" something with no intermediate feature or layer therebetween (i.e., directly on something).

Further, spatially relative terms, such as "beneath, " "below, " "lower, " "above, " "upper, " and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A layer can extend over the entirety of an underlying or overlying structure or may have an extent less than the extent of an underlying or overlying structure. Further, a layer can be a region of a homogeneous or inhomogeneous continuous structure that has a thickness less than the thickness of the continuous structure. For example, a layer can be located between any pair of horizontal planes between, or at, a top surface and a bottom surface of the continuous structure. A layer can extend horizontally, vertically, and/or along a tapered surface. A substrate can be a layer, can include one or more layers therein, and/or can have one or more layers thereupon, thereabove, and/or therebelow. A layer can include multiple layers. For example, a semiconductor layer can include one or more doped or undoped semiconductor layers and may have the same or different materials.

As used herein, the term "substrate" refers to a material onto which subsequent material layers are added. The substrate itselfcan be patterned. Materials added on top of the substrate can be patterned or can remain unpatterned. Furthermore, the substrate can include a wide array of semiconductor materials, such as silicon, silicon carbide, gallium nitride, germanium, gallium arsenide, indium phosphide, etc. Alternatively, the substrate can be made from an electrically non-conductive material, such as a glass, a plastic, or a sapphire wafer. Further alternatively, the substrate can have semiconductor devices or circuits formed therein.

As used herein, the term "micro" LED, "micro" p-n diode or "micro" device refers to the descriptive size of certain devices or structures according to implementations of the invention. As used herein, the terms "micro" devices or structures are meant to refer to the scale of 0.1 to 100 µm. However, it is to be appreciated that implementations of the present invention are not necessarily so limited, and that certain aspects of the implementations may be applicable to larger, and possibly smaller size scales.

Implementations of the present invention describe a LED structure or a micro-LED structure and a method for manufacturing the structure. For manufacturing a micro-LED display, an epitaxy layer is bonded to a receiving substrate. The receiving substrate, for example, may be, but is not limited to, a display substrate including a CMOS backplane or TFT glass substrate. Then the epitaxy layer is formed with an array of micro-LEDs on the receiving substrate. When forming the micro-LEDs on the receiving substrate, because the adhesion of the small functional mesas on the receiving substrate is weak and it is proportional to the mesa size, the plurality of small functional mesas may peel off from the receiving substrate and cause failure of a display (dead pixel) during the manufacturing process. To address the aforementioned issues, the present disclosure introduces a solution in which the functional LED mesas are isolated by an isolation material without performing etching process on the epitaxy layer, and therefore the adhesion area between the functional LEDs and the receiving substrate could be enlarged to avoid potential peeling off. In addition, the manufacturing method described in the present disclosure can further reduce physical damage of sidewalls of functional LED mesas, reduce damage of quantum well structure which is the light emitting region of the LED, and improve the optical and electrical properties of functional mesas.

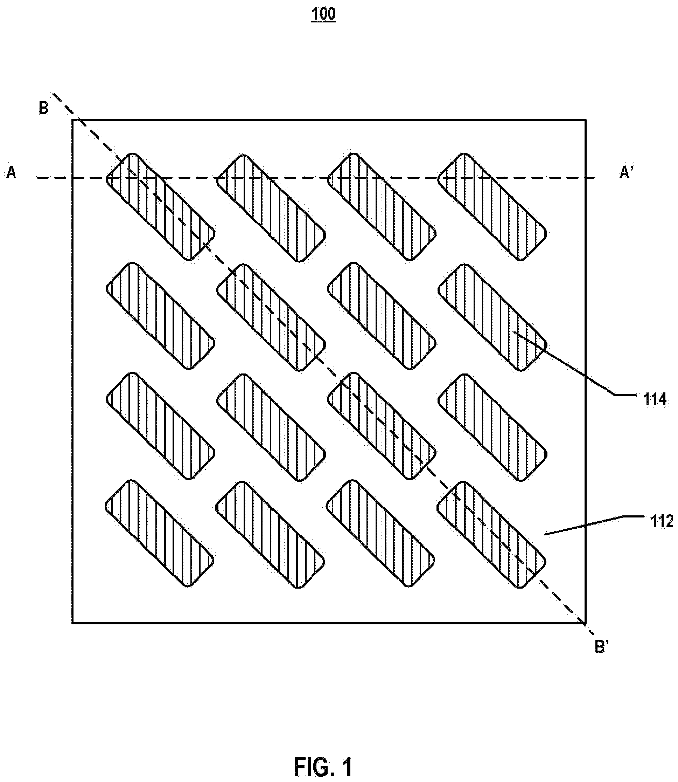

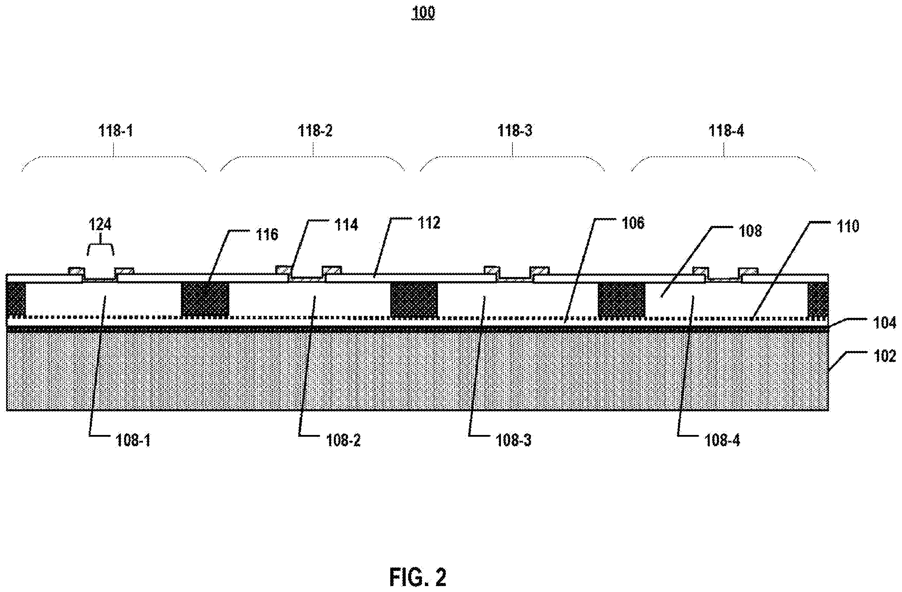

FIG. 1 illustrates a top view of an exemplary LED structure 100, according to some implementations of the present disclosure, and FIG. 2 illustrates a cross-section view of an exemplary LED structure 100 along line A-A', according to some implementations of the present disclosure. For the purpose of better explaining the present disclosure, the top view of LED structure 100 in FIG. 1 and the cross-section view of LED structure 100 in FIG. 2 will be described together. LED structure 100 includes a first substrate 102 and a plurality of LED units 118 (e.g., LED units 118-1, 118-2, 118-3, and 118-4 as shown in FIG. 2) . LED units 118 are bonded on first substrate 102 through a bonding layer 104. In some implementations, first substrate 102 may include a semiconductor material, such as silicon, silicon carbide, gallium nitride, germanium, gallium arsenide, indium phosphide. In some implementations, first substrate 102 may be made from an electrically non-conductive material, such as a glass, a plastic or a sapphire wafer. In some implementations, first substrate 102 may have driving circuits formed therein, and first substrate 102 may be CMOS backplane or TFT glass substrate. The driving circuit provides the electronic signals to LED units 118 to control the luminance. In some implementations, the driving circuit may include an active matrix driving circuit, in which each individual LED unit 118 corresponds to an independent driver. In some implementations, the driving circuit may include a passive matrix driving circuit, in which the plurality of LED units 118 are aligned in an array and are connected to the data lines and the scan lines driven by the driving circuit.

Bonding layer 104 is a layer of an adhesive material formed on first substrate 102 to bond first substrate 102 and LED units 118. In some implementations, bonding layer 104 may include a conductive material, such as metal or metal alloy. In some implementations, bonding layer 104 may include Au, Sn In Cu or Ti. In some implementations, bonding layer 104 may include a non-conductive material, such as polyimide (PI) , polydimethylsiloxane (PDMS) . In some implementations, bonding layer 104 may include a photoresist, such as SU-8 photoresist. In some implementations, bonding layer 104 may be hydrogen silsesquioxane (HSQ) or divinylsiloxane-bis-benzocyclobutene (DVS-BCB) . It is understood that the descriptions of the material of bonding layer 104 are merely illustrative and are not limiting, and those skilled in the art can change according to requirements, all of which are within the scope of the present application.

Referring to FIG. 2, each LED unit 118 includes its portion of bonding layer 104, a first doping type semiconductor layer 106, a second doping type semiconductor layer 108, and a multiple quantum well (MQW) layer 110 formed between first doping type semiconductor layer 106 and second doping type semiconductor layer 108. First doping type semiconductor layer 106 is formed on bonding layer 104. In some implementations, first doping type semiconductor layer 106 and second doping type semiconductor layer 108 may include one or more layers formed with II-VI materials, such as ZnSe or ZnO, or III-V nitride materials, such as GaN, AlN, InN, InGaN, GaP, AlInGaP, AlGaAs, and their alloys.

In some implementations, first doping type semiconductor layer 106 may be a p-type semiconductor layer that extends across multiple LED units 118 (e.g., four LED units 118 as illustrated in FIG. 2) and forms a common anode of these LED units 118. For example, first doping type semiconductor layer 106 of LED unit 118-2 extends to its adjacent LED units 118-1 and 118-3, and similarly, first doping type semiconductor layer 106 of LED unit 118-3 extends to its adjacent LED units 118-2 and 118-4. In some implementations, first doping type semiconductor layer 106 that extends across the LED units may be relatively thin. By having a thin layer of continuous first doping type semiconductor across the individual LED units, the bonding area between substrate 102 and the plurality of LED units 118 is not limited in the area beneath second doping type semiconductor layer 108 but also extends to the areas between the individual LED units. In other words, by having a thin layer of continuous first doping type semiconductor layer 106, the area of bonding layer 104 is increased. Hence, the bonding strength between substrate 102 and the plurality of LED units 118 is increased and the risk of peeling-off of LED structure 100 can be reduced.

In some implementations, first doping type semiconductor layer 106 may include p-type GaN. In some implementations, first doping type semiconductor layer 106 may be formed by doping magnesium (Mg) in GaN. In some implementations, first doping type semiconductor layer 106 may include p-type InGaN. In some implementations, first doping type semiconductor layer 106 may include p-type AlInGaP. Each of LED units 118 has an anode and a cathode connected to the driving circuit, e.g., one that is formed in substrate 102 (driving circuit not explicitly shown) . For example, each LED unit 118 has the anode connected to a constant voltage source and has the cathode connected to a source/drain electrode of the driving circuit. In other words, by forming the continuous first doping type semiconductor layer 106 across the individual LED units 118, the plurality of LED units 118 have a common anode formed by first doping type semiconductor layer 106 and bonding layer 104.

In some implementations, second doping type semiconductor layer 108 may be a n-type semiconductor layer and form a cathode of each LED unit 118. In some implementations, second doping type semiconductor layer 108 may include n-type GaN. In some implementations, second doping type semiconductor layer 108 may include n-type InGaN. In some implementations, second doping type semiconductor layer 108 may include n-type AlInGaP. Second doping type semiconductor layers 108 of different LED units 118 are electrically isolated, thus each LED unit 118 having a cathode that can have a voltage level different from the other units. As a result of the disclosed implementations, a plurality of individually functionable LED units 118 are formed with their first doping type semiconductor layers 106 horizontally extended across the adjacent LED units, and their second doping type semiconductor layers 108 electrically isolated between the adjacent LED units. Each LED unit 118 further includes a multiple quantum well (MQW) layer 110 formed between first doping type semiconductor layer 106 and second doping type semiconductor layer 108. MQW layer 110 is the active region of LED unit 118.

According to the invention, the second doping type semiconductor layer 108 is divided by an isolation material 116. For example, as shown in FIG. 2, second doping type semiconductor layer 108 is divided into a plurality of LED mesas 108-1, 108-2, 108-3 and 108-4 by isolation material 116. In other words, LED mesas 108-1, 108-2, 108-3 and 108-4 are electrically isolated by isolation material 116 formed inbetween. For example, LED mesa 108-2 of LED unit 118-2 is electrically isolated with LED mesa 108-1 of LED unit 118-1 and LED mesa 108-3 of LED unit 118-3 by isolation material 116.

In some implementations, isolation material 116 may be an ion-implanted material. In some implementations, isolation material 116 may be formed by implanting ion materials in second doping type semiconductor layers 108. In some implementations, isolation material 116 may be formed by implanting H +, He +, N +, O +, F +, Mg +, Si +or Ar +ions in second doping type semiconductor layers 108. In some implementations, second doping type semiconductor layers 108 may be implanted with one or more ion materials to form isolation material 116. Isolation material 116 has the physical properties of electrical insulation. By implanting ion material in a defined area of second doping type semiconductor layers 108, the material of second doping type semiconductor layers 108 in the defined area may be transformed to isolation material 116, which electrically isolates LED mesas 108-1, 108-2, 108-3 and 108-4 from each other.

In some implementations, as shown in FIG. 2, isolation material 116 may be formed in second doping type semiconductor layers 108 for a depth not sufficient to penetrate MQW layer 110. MQW layer 110, first doping type semiconductor layer 106 and bonding layer 104 beneath each LED mesa horizontally extend to MQW layer 110. first doping type semiconductor layer 106 and bonding layer 104 beneath adjacent LED mesas. For example, MQW layer 110, first doping type semiconductor layer 106 and bonding layer 104 beneath LED mesa 108-2 horizontally extend to MQW layer 110, first doping type semiconductor layer 106 and bonding layer 104 beneath LED mesas 108-1 and 108-3.

In some implementations, the implantation depth of isolation material 116 may be controlled above MQW layer 110, as shown in FIG. 2. In some implementations, the implantation depth of isolation material 116 may be controlled to not penetrate MQW layer 110 and isolation material 116 stops short to contact first doping type semiconductor layer 106. It is understood that the location, shape, and depth of isolation material 116 shown in FIG. 2 are merely illustrative and are not limiting, and those skilled in the art can change according to requirements, all of which are within the scope of the present application.

As shown in FIG. 2, a passivation layer 112 is formed on second doping type semiconductor layer 108, including LED mesas 108-1, 108-2, 108-3 and 108-4 and isolation material 116. Passivation layer 112 may be used for protecting and isolating LED units 118. In some implementations, passivation layer 112 may include SiO 2, Al 2O 3, SiN or other suitable materials. In some implementations, passivation layer 112 may include polyimide, SU-8 photoresist, or other photo-patternable polymer. An electrode layer 114 is formed on a portion of passivation layer 112, and electrode layer 114 electrically connects second doping type semiconductor layer 108 through an opening 124 on passivation layer 112. In some implementations, electrode layer 114 may be conductive materials, such as indium tin oxide (ITO) , Cr, Ti, Pt, Au, Al, Cu, Ge or Ni.

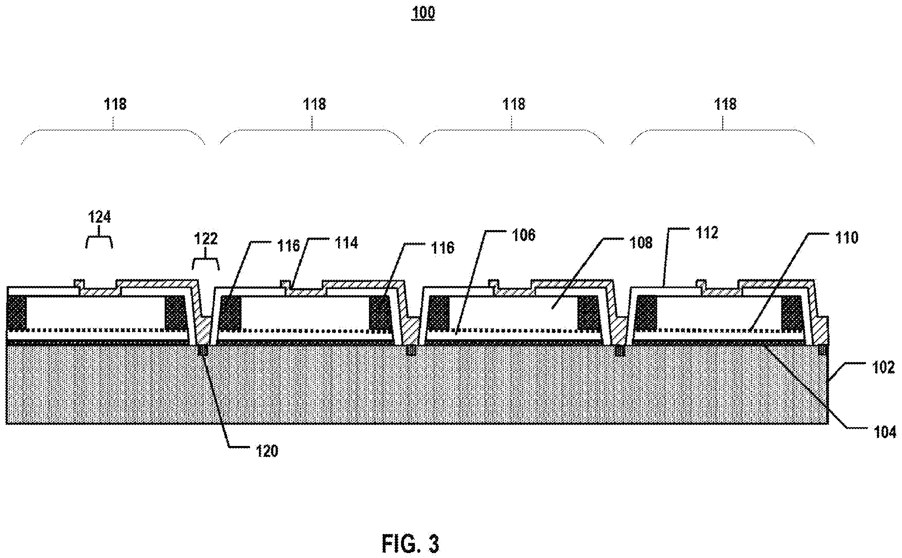

FIG. 3 illustrates another cross-section view of the exemplary LED structure 100 along line B-B', according to some implementations of the present disclosure. First substrate 102 has driving circuits formed therein for driving LED units 118. A contact 120 of the driving circuit is exposed in an opening 122 between two LED units 118, and contact 120 is electrically connected with second doping type semiconductor layer 108 through electrode layer 114. In other words, the electrical connection of second doping type semiconductor layer 108 and contact 120 of the driving circuit is accomplished by electrode layer 114. As described above, second doping type semiconductor layer 108 forms the cathode of each LED unit 118, hence contact 120 provides a driving voltage of the cathode of each LED unit 118 from the driving circuit to second doping type semiconductor layer 108 through electrode layer 114.

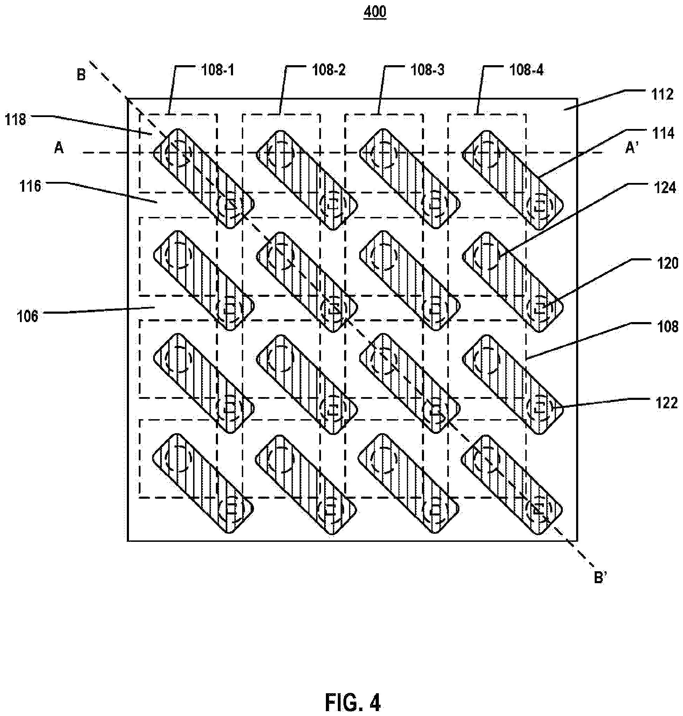

FIG. 4 illustrates another top view of LED structure 100, according to some implementations of the present disclosure. In FIG. 4, the layers beneath electrode layer 114 and passivation layer 112 are illustrated with dash lines for the purpose of explanation. In FIG. 4, LED structure 100 includes 16 LED units 118. Each LED unit 118 includes a p-n diode layer formed by first doping type semiconductor layer 106 and second doping type semiconductor layer 108 and multiple quantum well layer 110. Passivation layer 112 is formed on the p-n diode layer, and electrode layer 114 is formed on passivation layer 112.

Opening 124 is formed on passivation layer 112 exposing second doping type semiconductor layer 108, and opening 122 is formed on passivation layer 112 exposing contact 120. Electrode layer 114 is formed on a portion of passivation layer 112 covering opening 124 and opening 122, and therefore electrode layer 114 electrically connects with second doping type semiconductor layer 108 and contact 120. In the examples shown in FIG. 4, opening 124 is located at the center of each LED unit 118 and opening 122 is located at the interspace of adjacent LED units 118. It is understood that the locations and designs (such as shapes and sizes) of opening 124, opening 122 and electrode layer 114 may deviate from the examples shown in FIG. 4based on the specific implementations and are not limited here.

In FIG. 4, LED structure 100 includes 16 LED units 118, and each LED unit 118 is individually functionable. Second doping type semiconductor layer 108 of each LED unit 118 is electrically isolated by isolation material 116. First doping type semiconductor layer 106 locates under second doping type semiconductor layer 108 and passivation layer 112, and first doping type semiconductor layer 106 is the common anode of these 16 LED units 118. Consistent with the present disclosure, a plurality of LED units are referred to as "individually functionable" when first doping type semiconductor layer 106 of these LED units (e.g., the 16 LED units 118) is electrically connected not only during the manufacturing process of forming LED structure 100 but also after the manufacturing process and each LED unit 118 can be individually driven by a different driving circuit.

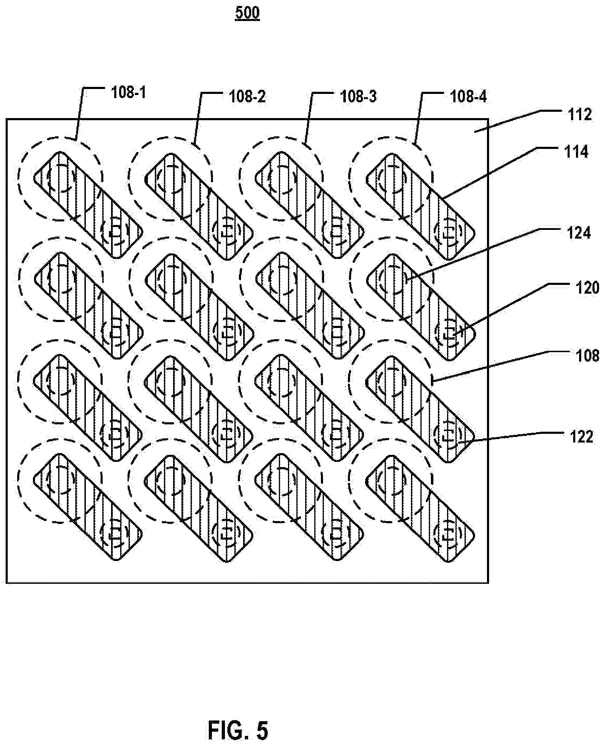

FIG. 5 illustrates a top view of another LED structure 500, according to some implementations of the present disclosure. The shape of LED mesa 108-1 in the top view in FIG. 5 is circular, which is different from the shape of LED mesa 108-1 in the top view of LED structure 100 shown in FIG. 4. By implanting ion material in a different defined area of second doping type semiconductor layers 108, the shape of LED mesa 108-1 may be formed differently. It is understood that, in some implementations, the position and shape of LED mesas in the top view may be changed according to various designs or applications, and the shape of LED mesas or LED unit 118 in the top view is not limited here. In some implementations, the position and shape of opening 124, opening 122, electrode layer 114 or contact 120 in the top view may be changed according to various designs and applications as well, and is not limited here.

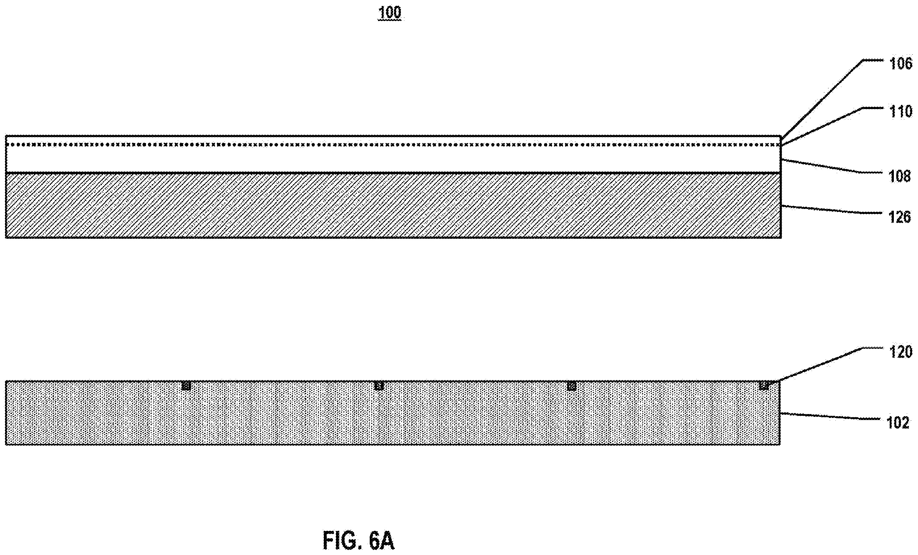

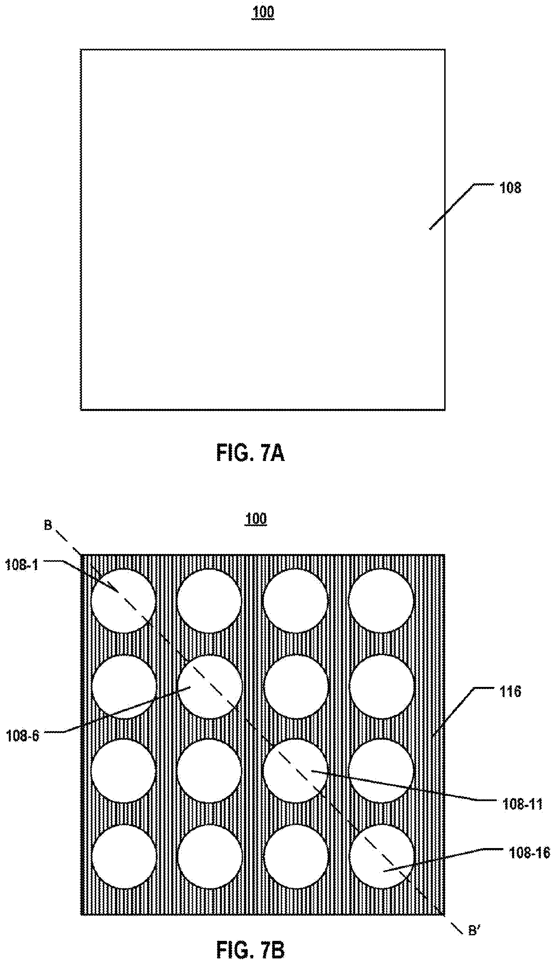

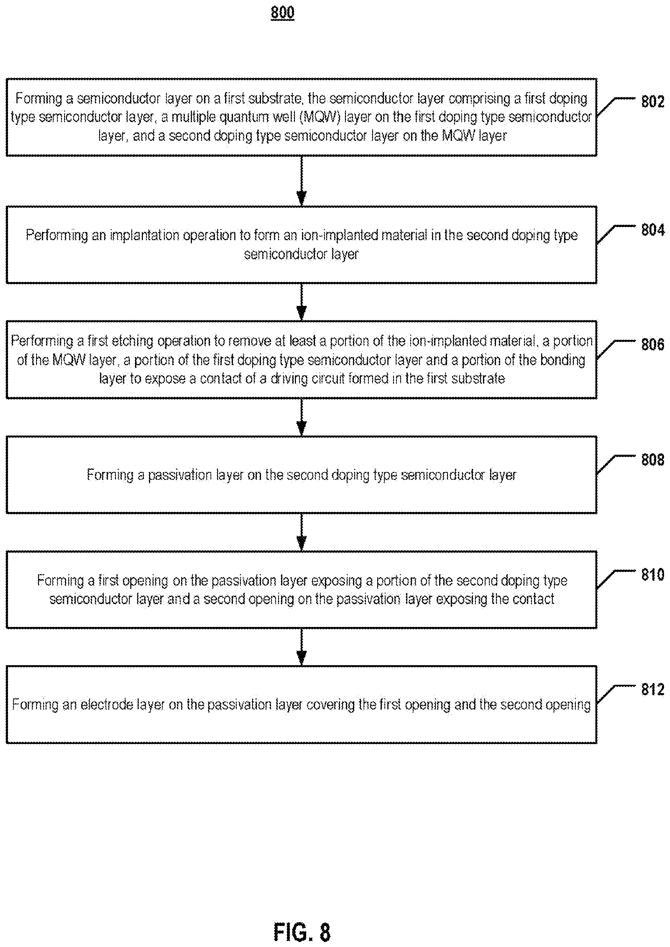

FIGs. 6A-6H illustrate cross sections of the exemplary LED structure 100 during a manufacturing process, according to some implementations of the present disclosure, FIGs. 7A-7D illustrate top views of LED structure 100 at different stages of a manufacturing process, according to some implementations of the present disclosure, and FIG. 8 is a flowchart of an exemplary method 800 for manufacturing LED structure 100, according to some implementations of the present disclosure. For the purpose of better explaining the present disclosure, FIGs. 6A-6H, FIGs. 7A-7D and FIG. 8 will be described together.

In FIG. 6A, a driving circuit is formed in first substrate 102 and the driving circuit includes contact 120. For example, the driving circuit may include CMOS devices manufactured on a silicon wafer and some wafer-level packaging layers or fan-out structures are stacked on the CMOS devices to form contact 120. For another example, the driving circuit may include TFTs manufactured on a glass substrate and some wafer-level packaging layers or fan-out structures are stacked on the TFTs to form contact 120. A semiconductor layer is formed on a second substrate 126, and the semiconductor layer includes first doping type semiconductor layer 106, second doping type semiconductor layer 108 and MQW layer 110.

In some implementations, first substrate 102 or second substrate 126 may include a semiconductor material, such as silicon, silicon carbide, gallium nitride, germanium, gallium arsenide, indium phosphide. In some implementations, first substrate 102 or second substrate 126 may be made from an electrically non-conductive material, such as a glass, a plastic or a sapphire wafer. In some implementations, first substrate 102 may have driving circuits formed therein, and first substrate 102 may include a CMOS backplane or TFT glass substrate. In some implementations, first doping type semiconductor layer 106 and second doping type semiconductor layer 108 may include one or more layers based on II-VI materials, such as ZnSe or ZnO, or III-V nitride materials, such as GaN, AlN, InN, InGaN, GaP, AlInGaP, AlGaAs, and their alloys. In some implementations, first doping type semiconductor layer 106 may include a p-type semiconductor layer, and second doping type semiconductor layer 108 may include a n-type semiconductor layer.

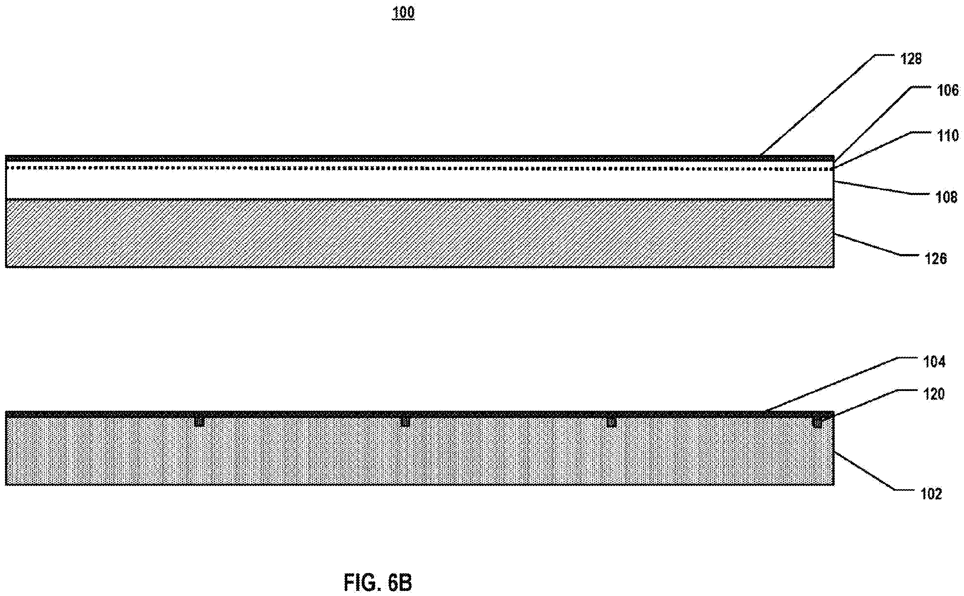

In FIG. 6B, bonding layer 104 is formed on first substrate 102. In some implementations, bonding layer 104 may include a conductive material, such as metal or metal alloy. In some implementations, bonding layer 104 may include Au, Sn In Cu or Ti. In some implementations, bonding layer 104 may include a non-conductive material, such as polyimide (PI), or polydimethylsiloxane (PDMS). In some implementations, bonding layer 104 may include a photoresist, such as SU-8 photoresist. In some implementations, bonding layer 104 may include hydrogen silsesquioxane (HSQ) or divinylsiloxane-bis-benzocyclobutene (DVS-BCB). In some implementations, a conductive layer 128 may be formed on first doping type semiconductor layer 106. In some implementations, conductive layer 128 may form a common electrode covering the entire first doping type semiconductor layer 106. In some implementations, conductive layer 128 may form an ohmic contact on first doping type semiconductor layer 106. In some implementations, conductive layer 128 and bonding layer 104 may be collectively referred to as one layer in later operations.

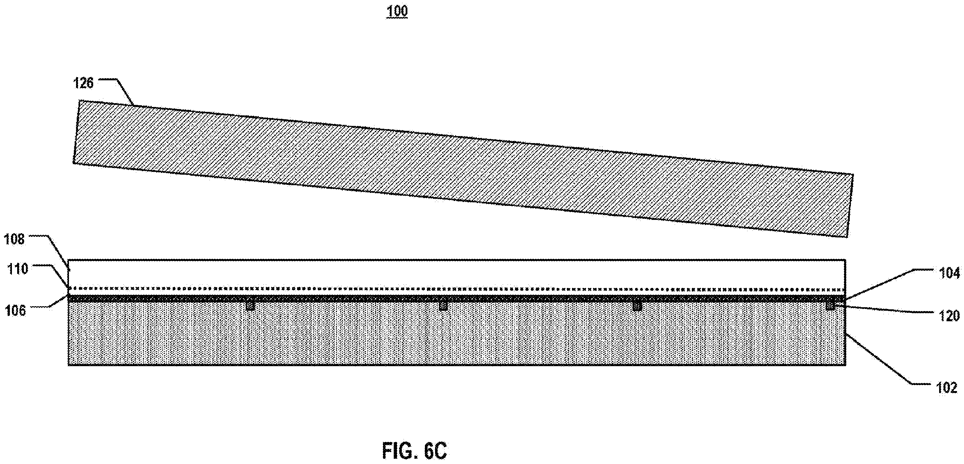

Referring to FIG. 6C and operation 802 of FIG. 8, second substrate 126 and the semiconductor layer, including first doping type semiconductor layer 106, second doping type semiconductor layer 108 and MQW layer 110, are flipped over and bonded to first substrate 102 through bonding layer 104 and conductive layer 128. Then, second substrate 126 may be removed from the semiconductor layer. FIG. 6C shows bonding layer 104 between first substrate 102 and first doping type semiconductor layer 106. However, in some implementations, bonding layer 104 may include one or multiple layers to bond first substrate 102 and first doping type semiconductor layer 106. For example, bonding layer 104 may include a single conductive or non-conductive layer. For another example, bonding layer 104 may include an adhesive layer and a conductive or non-conductive layer. In some implementations, bonding layer 104 and conductive layer 128 may be collectively referred to as one layer after operation 802. It is understood that the descriptions of the material of bonding layer 104 are merely illustrative and are not limiting, and those skilled in the art can change according to requirements, all of which are within the scope of the present application.

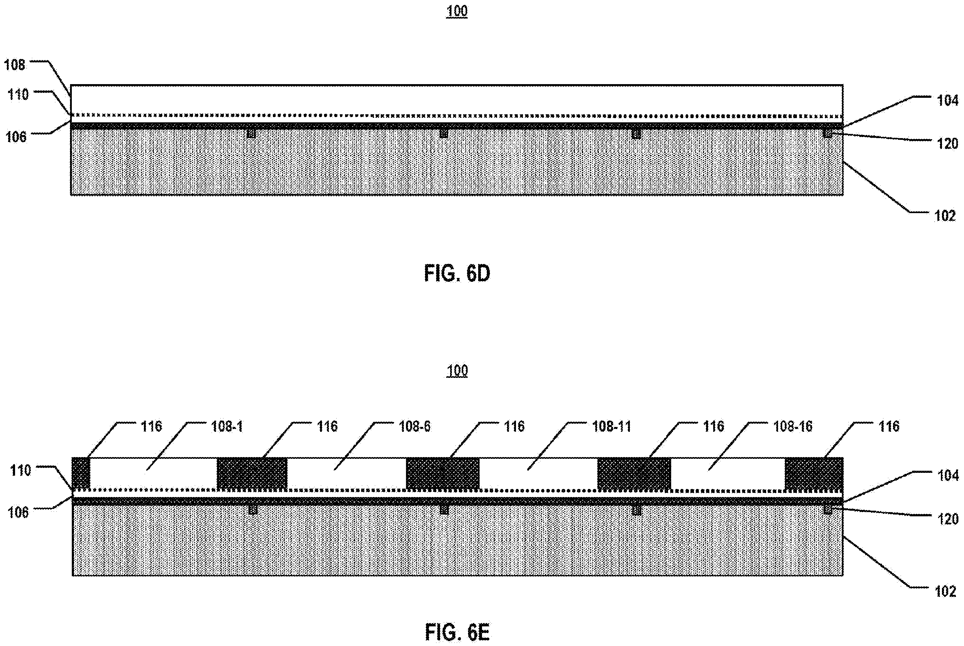

In FIG. 6D, a thinning operation may be performed on second doping type semiconductor layer 108 to remove a portion of second doping type semiconductor layer 108. FIG. 7A shows a top view of second doping type semiconductor layer 108 after the thinning operation. In some implementations, the thinning operation may include a dry etching or a wet etching operation. In some implementations, the thinning operation may include a chemicalmechanical polishing (CMP) operation. In some implementations, the thickness including first doping type semiconductor layer 106, MQW layer 110 and second doping type semiconductor layer 108 may be between about 0.3 µm and about 5 µm. In some other implementations, the thickness including first doping type semiconductor layer 106, MQW layer 110 and second doping type semiconductor layer 108 may be between about 0.4 µm and about 4 µm. In some alternative implementations, the thickness including first doping type semiconductor layer 106, MQW layer 110 and second doping type semiconductor layer 108 may be between about 0.5 µm and about 3 µm.

Referring to FIG. 6E and operation 804 of FIG. 8, an implantation operation is performed to form an isolation material 116 in second doping type semiconductor layer 108, and as a result of the implantation, second doping type semiconductor layer 108 is divided into a plurality of LED mesas 108-1, 108-6, 108-11 and 108-16 by isolation material 116. The plurality of LED mesas 108-1, 108-6, 108-11 and 108-16 are electrically isolated from each other by isolation material 116. FIG. 7B shows a top view of LED structure 100 after the implantation operation, and FIG. 6E shows the cross section along line BB' in FIG. 7B. In FIG. 7B, second doping type semiconductor layer 108 is divided into a plurality of LED mesas 108-1, 108-6, 108-11 and 108-16 by isolation material 116.

In some implementations, isolation material 116 may be formed by implanting ion materials to a defined region in second doping type semiconductor layers 108. In some implementations, isolation material 116 may be formed by implanting H +, He +, N +, O +, F +, Mg +, Si + or Ar + ions in second doping type semiconductor layers 108. In some implementations, second doping type semiconductor layers 108 may be implanted with one or more ion materials to form isolation material 116. Isolation material 116 has the physical properties of electrical insulation. By implanting ion material in a defined area of second doping type semiconductor layers 108, the material of second doping type semiconductor layers 108 in the defined area may be transformed to isolation material 116 and electrically isolate LED mesas 108-1, 108-6, 108-11 and 108-16. In some implementations, the implantation operation may be performed with an implantation energy between about 10 keV and about 300 keV. In some implementations, the implantation operation may be performed with an implantation energy between about 15 keV and about 250 keV. In some implementations, the implantation operation may be performed with an implantation energy between about 20 keV and about 200 keV.

In some implementations, isolation material 116 may be formed in second doping type semiconductor layers 108 for a depth not sufficient to penetrate MQW layer 110. MQW layer 110, first doping type semiconductor layer 106 and bonding layer 104 beneath each LED mesa horizontally extend to MQW layer 110, first doping type semiconductor layer 106 and bonding layer 104 beneath adjacent LED mesas. For example, MQW layer 110, first doping type semiconductor layer 106 and bonding layer 104 beneath LED mesa 108-6 horizontally extend to MQW layer 110, first doping type semiconductor layer 106 and bonding layer 104 beneath LED mesas 108-1 and 108-11.

In some implementations, the implantation depth of isolation material 116 may be controlled so that isolation material 116 stops short to contact MQW layer 110, as shown in FIG. 6E. In some implementations, the implantation depth of isolation material 116 may be controlled to not penetrate MQW layer 110 and isolation material stops short to contact first doping type semiconductor layer 106. It is understood that the location, shape, and depth of isolation material 116 shown in FIG. 6E are merely illustrative and are not limiting, and those skilled in the art can change according to specific implementations, all of which are within the scope of the present application.

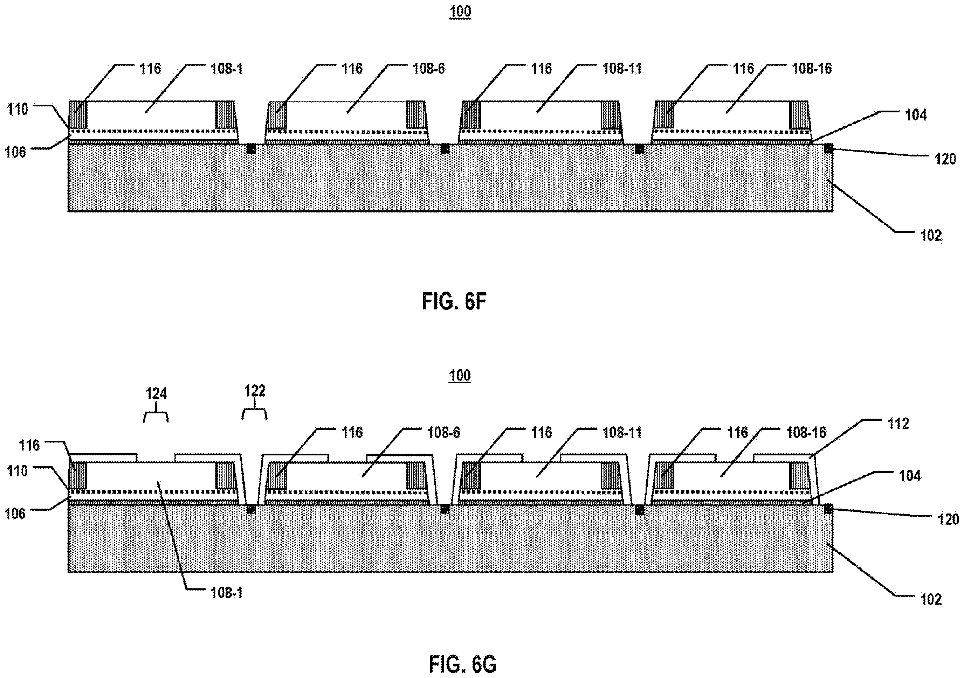

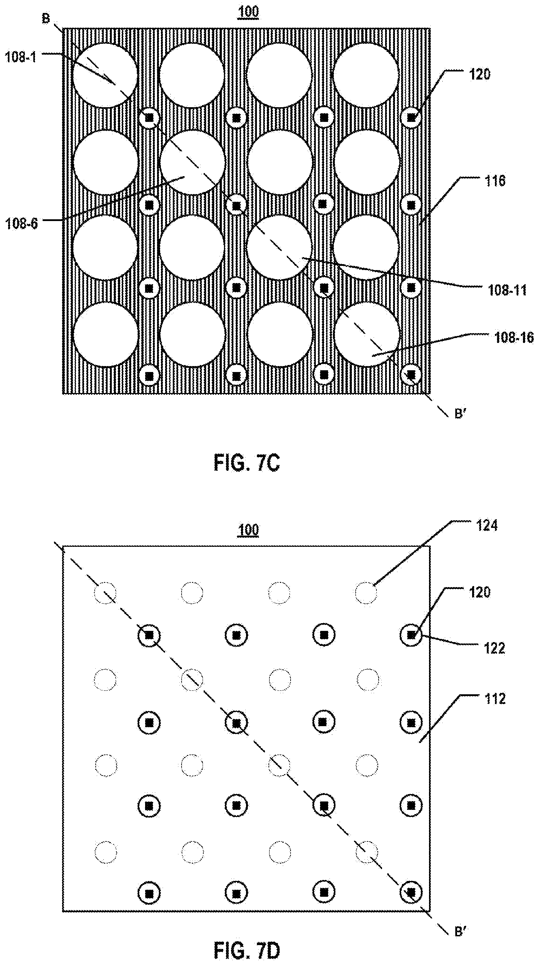

Referring to FIG. 6F and operation 806 of FIG. 8, a first etching operation is performed to remove a portion of isolation material 116, a portion of MQW layer 110, and a portion of first doping type semiconductor layer106 to expose contact 120 of the driving circuit formed in first substrate 102. FIG. 7C shows a top view of LED structure 100 after the first etching operation. The first etching operation may be a dry etching or a wet etching operation. In a dry etching operation or a wet etching operation, a hard mask (e.g., a photoresist) may be formed on second doping type semiconductor layer 108 by photolithography process. Then, the uncovered portion of second doping type semiconductor layer 108 is removed by dry etching plasma or wet etching solution to expose contact 120. During the first etching operation, LED mesas are protected by isolation material 116, and the physical damage of sidewalls of LED mesas can be therefore prevented.

Referring to FIG. 6G and operations 808 and 810 of FIG. 8, passivation layer 112 is formed on second doping type semiconductor layer 108, and first opening 124 is formed on passivation layer 112 exposing a portion of second doping type semiconductor layer 108 and second opening 122 is formed on passivation layer 112 exposing contact 120. FIG. 7D shows a top view of LED structure 100 after forming openings 122 and 124. The LED structure 100 is covered by passivation layer 112 and openings 122 and 124 expose second doping type semiconductor layer 108 and contacts 120.

In some implementations, passivation layer 112 may include SiO 2, Al2O 3, SiN or other suitable materials for isolation and protection. In some implementations, passivation layer 112 may include polyimide, SU-8 photoresist, or other photo-patternable polymer. In operation 810 of FIG. 8, opening 124 and opening 122 are formed to expose a portion of second doping type semiconductor layer 108 and expose contact 120. In some implementations, operation 810 may be performed by a second etching operation to remove a portion of passivation layer 112 and form opening 124 and opening 122. In some further implementations, provided passivation layer 112 is formed by a photo-sensitive material (e.g., polyimide, SU-8 photoresist, or other photo-patternable polymer) , operation 810 may be performed by a photolithography operation to pattern passivation layer 112 and expose opening 124 and opening 122.

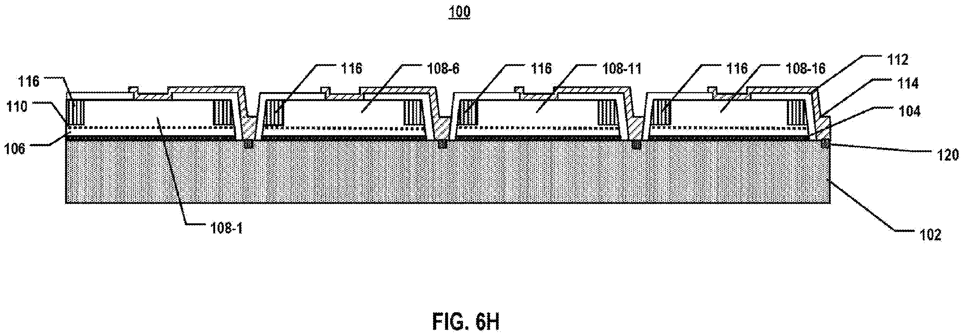

Referring to FIG. 6H and operation 812 of FIG. 8, electrode layer 114 is formed on passivation layer 112 covering opening 124 and opening 122. The top view of LED structure 100 after operation 812 is shown in FIG. 1. Electrode layer 114 electrically connects second doping type semiconductor layer 108 and contact 120 and forms an electrical path to connect the LED unit with the driving circuit in substrate 102. The driving circuit may control the voltage and current level of second doping type semiconductor layer 108 through contact 120 and electrode layer 114. In some implementations, electrode layer 114 may include conductive materials, such as indium tin oxide (ITO) , Cr, Ti, Pt, Au, Al, Cu, Ge or Ni.

The present disclosure provides a LED structure and a method for manufacture the LED structure in which second doping type semiconductor layer 108 is divided by isolation material 116. The functional LED mesas are divided by isolation material 116 without performing etching process on the epitaxy layer, and therefore the adhesion area between the functional LEDs and the receiving substrate could be enlarged to avoid potential peeling off. Because ion-implanted semiconductor material may have a physical characteristic of high electrical resist, the current flow of LED units could be confined within a certain semiconductor layer, which define the light emitting areas. By using ion implantation to form the isolation material in the semiconductor functional epitaxy layer to form highly resistive region, the present disclosure may eliminate the use of wet etching or dry etching in the formation of LED mesas, avoid the physical damage of sidewall of LED mesas, and improve the optical and electrical properties of LED units. Furthermore, without using conventional isolation trenches between mesas, the space and density of micro-LED array limited by the physical trenches could be greatly improved.

According to one aspect of the present disclosure, a LED structure is disclosed. The LED structure includes a substrate, a bonding layer, a first doping type semiconductor layer, a multiple quantum well (MQW) layer, a second doping type semiconductor layer, a passivation layer and an electrode layer. The bonding layer is formed on the substrate, and the first doping type semiconductor layer is formed on the bonding layer. The MQW layer is formed on the first doping type semiconductor layer, and the second doping type semiconductor layer is formed on the MQW layer. The second doping type semiconductor layer includes an isolation material made through implantation, and the passivation layer is formed on the second doping type semiconductor layer. The electrode layer is formed on the passivation layer in contact with a portion of the second doping type semiconductor layer through a first opening on the passivation layer.

According to the invention, the isolation material divides the second doping type semiconductor layer into a plurality of LED mesas. According to the invention, the LED structure further includes a plurality of contacts of a driving circuit formed in the substrate, and each contact is located at an interspace of adjacent LED mesas. According to the invention, the electrode layer electrically connects the second doping type semiconductor layer and the contact through the first opening and a second opening on each contact.

According to the invention, the plurality of LED mesas include a first LED mesa and a second LED mesa adjacent to the first LED mesa, and the MQW layer, the first doping type semiconductor layer and the bonding layer beneath the first LED mesa horizontally extend to the MQW layer, the first doping type semiconductor layer and the bonding layer beneath the second LED mesa. In some implementations, the isolation material includes an ion-implanted material.

According to a further aspect of the present disclosure, a method for manufacturing a LED structure is disclosed. A semiconductor layer is formed on a first substrate. The semiconductor layer includes a first doping type semiconductor layer, a MQW layer on the first doping type semiconductor layer, and a second doping type semiconductor layer on the MQW layer. An implantation operation is performed to form an ion-implanted material in the second doping type semiconductor layer. A first etching operation is performed to remove at least a portion of the ion-implanted material, a portion of the MQW, a portion of the first doping type semiconductor layer and a portion of the bonding layer to expose a contact of a driving circuit formed in the first substrate. A passivation layer is formed on the second doping type semiconductor layer. A first opening is formed on the passivation layer exposing a portion of the second doping type semiconductor layer and a second opening is formed on the passivation layer exposing the contact on the first substrate. An electrode layer is formed on the passivation layer covering the first opening and the second opening.

According to the invention, the ion-implanted material is formed in the second doping type semiconductor layer through implantation to divide the second doping type semiconductor layer into a plurality of LED mesas, and each LED mesa is electrically isolated by the ion-implanted material. In some implementations, an ion material is implanted to a defined region of the semiconductor layer with an implantation depth so that the ion-implanted material does not contact the first doping type semiconductor layer. In some implementations, an ion material is implanted to a defined region of the semiconductor layer with an implantation depth so that the ion-implanted material does not contact the first doping type semiconductor layer and the MQW layer.

In some implementations, the implantation operation is performed with an implantation energy between about 10 keV and about 300 keV. In some implementations, the ion material includes hydrogen, helium, nitrogen, oxygen, fluorine, magnesium, silicon, or argon ion.

According to the invention, a driving circuit is formed in the first substrate, the semiconductor layer is formed on a second substrate, the semiconductor layer is bonded onto the first substrate through a bonding layer, and the second substrate is removed.

The foregoing description of the specific implementations can be readily modified and/or adapted for various applications.

The scope of the present invention is defined by the claims and should not be limited by any of the above-described exemplary implementations.

## Claims

1. A light emitting diode, LED, structure (100), comprising:
a substrate (102);
a bonding layer (104) formed on the substrate (102);
a first doping type semiconductor layer (106) formed on the bonding layer (104);
a multiple quantum well, MQW, layer (110) formed on the first doping type semiconductor layer (106); and
a second doping type semiconductor layer (108) formed on the MQW layer (110), wherein the second doping type semiconductor layer (108) comprises an isolation material (116) made through implantation;
a passivation layer (112) formed on the second doping type semiconductor layer (108); and
an electrode layer (114) formed on the passivation layer (112) in contact with a portion of the second doping type semiconductor layer (108) through a first opening (124) on the passivation layer (112),
wherein the isolation material (116) divides the second doping type semiconductor layer (108) into a plurality of LED mesas (108-1, 108-2, 108-3, 108-4), and the plurality of LED mesas (108-1, 108-2, 108-3, 108-4) correspond to a plurality of LED units (118-1, 118-2, 118-3, 118-4), respectively, and
the LED structure (100) further comprises:
a plurality of contacts (120) of a driving circuit formed in the substrate (102), wherein each contact (120) is located at an interspace of adjacent LED mesas (108-1, 108-2, 108-3, 108-4), the electrode layer (114) electrically connects the second doping type semiconductor layer (108) and the contact (120) through the first opening (124) and a second opening (122) on each contact (120), and each LED unit (118-1, 118-2, 118-3, 118-4) is individually driven by a corresponding contact (120) of the driving circuit, and
the plurality of LED mesas (108-1, 108-2, 108-3, 108-4) comprise a first LED mesa and a second LED mesa adjacent to the first LED mesa, wherein the MQW layer (110), the first doping type semiconductor layer (106) and the bonding layer (104) beneath the first LED mesa horizontally extend to the MQW layer (110), the first doping type semiconductor layer (106) and the bonding layer (104) beneath the second LED mesa.

2. The LED structure (100) of claim 1, wherein the isolation material comprises an ion-implanted material.

3. The LED structure (100) of claim 2, wherein the ion-implanted material comprises hydrogen, helium, nitrogen, oxygen, fluorine, magnesium, silicon, or argon ion implanted material.

4. The LED structure (100) of any one of claims 1 to 3, wherein each LED unit (118-1, 118-2, 118-3, 118-4) comprises:
the bonding layer (104) formed on the substrate (102);
the first doping type semiconductor layer (106) formed on the bonding layer (104);
the MQW layer (110) formed on the first doping type semiconductor layer (106); and
the second doping type semiconductor layer (108) formed on the MQW layer (110),
wherein the plurality of LED units (118-1, 118-2, 118-3, 118-4) comprises a first LED unit and a second LED unit adjacent to the first LED unit, and
the second doping type semiconductor layer (108) of the first LED unit is electrically isolated with the second doping type semiconductor layer (108) of the second LED unit by the isolation material.

5. A method for manufacturing a light emitting diode, LED, structure (100), comprising:
forming a semiconductor layer on a first substrate (102), the semiconductor layer comprising a first doping type semiconductor layer (106), a multiple quantum well, MQW,
layer (110) on the first doping type semiconductor layer (106), and a second doping type semiconductor layer (108) on the MQW layer (110);
performing an implantation operation to form an ion-implanted material in the second doping type semiconductor layer (108), to divide the second doping type semiconductor layer (108) into a plurality of LED mesas (108-1, 108-2, 108-3, 108-4), wherein each LED mesa is electrically isolated by the ion-implanted material;
performing a first etching operation to remove at least a portion of the ion-implanted material, a portion of the MQW layer (110), a portion of the first doping type semiconductor layer (106) and a portion of a bonding layer (104) to expose a plurality of contacts (120) of a driving circuit formed in the first substrate (102);
forming a passivation layer (112) on the second doping type semiconductor layer (108);
forming a first opening (124) on the passivation layer (112) exposing a portion of the second doping type semiconductor layer (108) and a second opening (122) on the passivation layer (112) exposing the contact (120); and
forming an electrode layer (114) on the passivation layer (112) covering the first opening (124) and the second opening (122),
wherein each contact (120) is located at an interspace of adjacent LED mesas (108-1, 108-2, 108-3, 108-4), and the electrode layer (114) electrically connects the second doping type semiconductor layer (108) and the contact (120) through the first opening (124) and the second opening (122) on each contact (120), and
the plurality of LED mesas (108-1, 108-2, 108-3, 108-4) comprise a first LED mesa and a second LED mesa adjacent to the first LED mesa, and the MQW layer (110), the first doping type semiconductor layer (106) and the bonding layer (104) beneath the first LED mesa horizontally extend to the MQW layer (110), the first doping type semiconductor layer (106) and the bonding layer (104) beneath the second LED mesa, and
the plurality of LED mesas (108-1, 108-2, 108-3, 108-4) correspond to a plurality of LED units (118-1, 118-2, 118-3, 118-4), respectively, and each LED unit (118-1, 118-2, 118-3, 118-4) is individually driven by a corresponding contact (120) of the driving circuit.

6. The method of claim 5, wherein the implantation operation is performed with an implantation energy between about 10 keV and about 300 keV

7. The method of claim 5 or 6, wherein forming the semiconductor layer on the first substrate (102), comprises:
forming the driving circuit in the first substrate (102);
forming the semiconductor layer on a second substrate (126);
bonding the semiconductor layer onto the first substrate (102) through the bonding layer (104); and
removing the second substrate (126).

## Patentansprüche

1. Eine Leuchtdiodenstruktur, LED-Struktur, (100), die Folgendes beinhaltet:
ein Substrat (102);
eine Bondingschicht (104), die auf dem Substrat (102) gebildet ist;
eine erste Dotierungstyphalbleiterschicht (106), die auf der Bondingschicht (104) gebildet ist;
eine Multiple-Quantum-Well-Schicht, MQW-Schicht, (110), die auf der ersten Dotierungstyphalbleiterschicht (106) gebildet ist; und
eine zweite Dotierungstyphalbleiterschicht (108), die auf der MQW-Schicht (110) gebildet ist, wobei die zweite Dotierungstyphalbleiterschicht (108) ein Isolierungsmaterial (116) beinhaltet, das durch Implantation hergestellt wird;
eine Passivierungsschicht (112), die auf der zweiten Dotierungstyphalbleiterschicht (108) gebildet ist; und
eine Elektrodenschicht (114), die auf der Passivierungsschicht (112) in Kontakt mit einem Teil der zweiten Dotierungstyphalbleiterschicht (108) durch eine erste Öffnung (124) auf der Passivierungsschicht (112) gebildet ist,
wobei das Isolierungsmaterial (116) die zweite Dotierungstyphalbleiterschicht (108) in eine Vielzahl von LED-Mesas (108-1, 108-2, 108-3, 108-4) teilt und die Vielzahl von LED-Mesas (108-1, 108-2, 108-3, 108-4) jeweils einer Vielzahl von LED-Einheiten (118-1, 118-2, 118-3, 118-4) entsprechen, und
die LED-Struktur (100) ferner Folgendes beinhaltet:
eine Vielzahl von Kontakten (120) eines Steuerkreises, der in dem Substrat (102) gebildet ist, wobei sich jeder Kontakt (120) in einem Zwischenraum benachbarter LED-Mesas (108-1, 108-2, 108-3, 108-4) befindet, die Elektrodenschicht (114) die zweite Dotierungstyphalbleiterschicht (108) und den Kontakt (120) durch die erste Öffnung (124) und eine zweite Öffnung (122) auf jedem Kontakt (120) elektrisch verbindet und jede LED-Einheit (118-1, 118-2, 118-3, 118-4) durch einen entsprechenden Kontakt (120) des Steuerkreises individuell angesteuert wird, und
die Vielzahl von LED-Mesas (108-1, 108-2, 108-3, 108-4) eine erste LED-Mesa und eine zweite LED-Mesa benachbart zu der ersten LED-Mesa beinhalten, wobei die MQW-Schicht (110), die erste Dotierungstyphalbleiterschicht (106) und die Bondingschicht (104) unter der ersten LED-Mesa sich horizontal zu der MQW-Schicht (110), der ersten Dotierungstyphalbleiterschicht (106) und der Bondingschicht (104) unter der zweiten LED-Mesa erstrecken.

2. LED-Struktur (100) gemäß Anspruch 1, wobei das Isolierungsmaterial ein ionenimplantiertes Material beinhaltet.

3. LED-Struktur (100) gemäß Anspruch 2, wobei das ionenimplantierte Material ionenimplantiertes Wasserstoff-, Helium-, Stickstoff-, Sauerstoff-, Fluor-, Magnesium-, Silicium- oder Argonmaterial beinhaltet.

4. LED-Struktur (100) gemäß einem der Ansprüche 1 bis 3, wobei jede LED-Einheit (118-1, 118-2, 118-3, 118-4) Folgendes beinhaltet:
die Bondingschicht (104), die auf dem Substrat (102) gebildet ist;
die erste Dotierungstyphalbleiterschicht (106), die auf der Bondingschicht (104) gebildet ist;
die MQW-Schicht (110), die auf der ersten Dotierungstyphalbleiterschicht (106) gebildet ist; und
die zweite Dotierungtyphalbleiterschicht (108), die auf der MQW-Schicht (110) gebildet ist,
wobei die Vielzahl von LED-Einheiten (118-1, 118-2, 118-3, 118-4) eine erste LED-Einheit und eine zweite LED-Einheit benachbart zu der ersten LED-Einheit beinhaltet, und
die zweite Dotierungstyphalbleiterschicht (108) der ersten LED-Einheit mit der zweiten Dotierungstyphalbleiterschicht (108) der zweiten LED-Einheit durch das Isolierungsmaterial elektrisch isoliert ist.

5. Ein Verfahren zum Fertigen einer Leuchtdiodenstruktur, LED-Struktur, (100), das Folgendes beinhaltet:
Bilden einer Halbleiterschicht auf einem ersten Substrat (102), wobei die Halbleiterschicht eine erste Dotierungstyphalbleiterschicht (106), eine Multiple-Quantum-Well-Schicht, MQW-Schicht, (110) auf der ersten
Dotierungstyphalbleiterschicht (106) und eine zweite Dotierungstyphalbleiterschicht (108) auf der MQW-Schicht (110) beinhaltet;
Durchführen einer Implantationsoperation, um ein ionenimplantiertes Material in der zweiten Dotierungstyphalbleiterschicht (108) zu bilden, um die zweite Dotierungstyphalbleiterschicht (108) in eine Vielzahl von LED-Mesas (108-1, 108-2, 108-3, 108-4) zu teilen, wobei jede LED-Mesa durch das ionenimplantierte Material elektrisch isoliert ist;
Durchführen einer ersten Ätzoperation, um mindestens einen Teil des ionenimplantierten Materials, einen Teil der MQW-Schicht (110), einen Teil der ersten Dotierungstyphalbleiterschicht (106) und einen Teil einer Bondingschicht (104) zu entfernen, um eine Vielzahl von Kontakten (120) eines Steuerkreises, der in dem ersten Substrat (102) gebildet ist, freizulegen;
Bilden einer Passivierungsschicht (112) auf der zweiten Dotierungstyphalbleiterschicht (108);
Bilden einer ersten Öffnung (124) auf der Passivierungsschicht (112), die einen Teil der zweiten Dotierungstyphalbleiterschicht (108) freilegt, und einer zweiten Öffnung (122) auf der Passivierungsschicht (112), die den Kontakt (120) freilegt; und
Bilden einer Elektrodenschicht (114) auf der Passivierungsschicht (112), die die erste Öffnung (124) und die zweite Öffnung (122) bedeckt,
wobei sich jeder Kontakt (120) in einem Zwischenraum benachbarter LED-Mesas (108-1, 108-2, 108-3, 108-4) befindet und die Elektrodenschicht (114) die zweite Dotierungstyphalbleiterschicht (108) und den Kontakt (120) durch die erste Öffnung (124) und die zweite Öffnung (122) auf jedem Kontakt (120) elektrisch verbindet, und die Vielzahl von LED-Mesas (108-1, 108-2, 108-3, 108-4) eine erste LED-Mesa und
eine zweite LED-Mesa benachbart zu der ersten LED-Mesa beinhalten und die MQW-Schicht (110), die erste Dotierungstyphalbleiterschicht (106) und die Bondingschicht (104) unter der ersten LED-Mesa sich horizontal zu der MQW-Schicht (110), der ersten Dotierungstyphalbleiterschicht (106) und der Bondingschicht (104) unter der zweiten LED-Mesa erstrecken, und
die Vielzahl von LED-Mesas (108-1, 108-2, 108-3, 108-4) jeweils einer Vielzahl von LED-Einheiten (118-1, 118-2, 118-3, 118-4) entsprechen und jede LED-Einheit (118-1, 118-2, 118-3, 118-4) von einem entsprechenden Kontakt (120) des Steuerkreises individuell angesteuert wird.

6. Verfahren gemäß Anspruch 5, wobei die Implantationsoperation mit einer Implantationsenergie zwischen etwa 10 keV und etwa 300 keV durchgeführt wird.

7. Verfahren gemäß Anspruch 5 oder 6, wobei das Bilden der Halbleiterschicht auf dem ersten Substrat (102) Folgendes beinhaltet:
Bilden des Steuerkreises in dem ersten Substrat (102);
Bilden der Halbleiterschicht auf einem zweiten Substrat (126);
Bonden der Halbleiterschicht auf das erste Substrat (102) durch die Bondingschicht (104); und
Entfernen des zweiten Substrats (126).

## Revendications

1. Une structure de diode électroluminescente, DEL, (100), comprenant :
un substrat (102) ;
une couche de liaison (104) formée sur le substrat (102) ;
une couche de semiconducteur d'un premier type de dopage (106) formée sur la couche de liaison (104) ;
une couche de multipuits quantique, MQW, (110) formée sur la couche de semiconducteur d'un premier type de dopage (106) ; et
une couche de semiconducteur d'un deuxième type de dopage (108) formée sur la couche de MQW (110), où la couche de semiconducteur d'un deuxième type de dopage (108) comprend un matériau d'isolement (116) produit par une implantation ;
une couche de passivation (112) formée sur la couche de semiconducteur d'un deuxième type de dopage (108) ; et
une couche d'électrode (114) formée sur la couche de passivation (112) en contact avec une portion de la couche de semiconducteur d'un deuxième type de dopage (108) par l'intermédiaire d'une première ouverture (124) sur la couche de passivation (112),
où le matériau d'isolement (116) divise la couche de semiconducteur d'un deuxième type de dopage (108) en une pluralité de mésas de DEL (108-1, 108-2, 108-3, 108-4),
et la pluralité de mésas de DEL (108-1, 108-2, 108-3, 108-4) correspond à une pluralité d'unités de DEL (118-1, 118-2, 118-3, 118-4), respectivement, et
la structure de DEL (100) comprend en outre :
une pluralité de contacts (120) d'un circuit d'excitation formé dans le substrat (102), où chaque contact (120) est situé au niveau d'un écartement de mésas de DEL (108-1, 108-2, 108-3, 108-4) adjacentes, la couche d'électrode (114) connecte électriquement la couche de semiconducteur d'un deuxième type de dopage (108) et le contact (120) par l'intermédiaire de la première ouverture (124) et d'une deuxième ouverture (122) sur chaque contact (120), et chaque unité de DEL (118-1, 118-2, 118-3, 118-4) est excitée individuellement par un contact (120) correspondant du circuit d'excitation, et
la pluralité de mésas de DEL (108-1, 108-2, 108-3, 108-4) comprend une première mésa de DEL et une deuxième mésa de DEL adjacente à la première mésa de DEL, où la couche de MQW (110), la couche de semiconducteur d'un premier type de dopage (106) et la couche de liaison (104) sous la première mésa de DEL s'étendent horizontalement par rapport à la couche de MQW (110), à la couche de semiconducteur d'un premier type de dopage (106) et à la couche de liaison (104) sous la deuxième mésa de DEL.

2. La structure de DEL (100) de la revendication 1, où le matériau d'isolement comprend un matériau implanté par ions.

3. La structure de DEL (100) de la revendication 2, où le matériau implanté par ions comprend un matériau implanté par ions d'hydrogène, d'hélium, d'azote, d'oxygène, de fluor, de magnésium, de silicium, ou d'argon.

4. La structure de DEL (100) de l'une quelconque des revendications 1 à 3, où chaque unité de DEL (118-1, 118-2, 118-3, 118-4) comprend :
la couche de liaison (104) formée sur le substrat (102) ;
la couche de semiconducteur d'un premier type de dopage (106) formée sur la couche de liaison (104) ;
la couche de MQW (110) formée sur la couche de semiconducteur d'un premier type de dopage (106) ; et
la couche de semiconducteur d'un deuxième type de dopage (108) formée sur la couche de MQW (110),
où la pluralité d'unités de DEL (118-1, 118-2, 118-3, 118-4) comprend une première unité de DEL et une deuxième unité de DEL adjacente à la première unité de DEL, et
la couche de semiconducteur d'un deuxième type de dopage (108) de la première unité de DEL est isolée électriquement de la couche de semiconducteur d'un deuxième type de dopage (108) de la deuxième unité de DEL par le matériau d'isolement.

5. Un procédé pour la fabrication d'une structure de diode électroluminescente, DEL, (100), comprenant :
la formation d'une couche de semiconducteur sur un premier substrat (102), la couche de semiconducteur comprenant une couche de semiconducteur d'un premier type de dopage (106), une couche de multipuits quantique, MQW, (110) sur la couche de semiconducteur d'un premier type de dopage (106), et une couche de semiconducteur d'un deuxième type de dopage (108) sur la couche de MQW (110) ;
la réalisation d'une opération d'implantation pour former un matériau implanté par ions dans la couche de semiconducteur d'un deuxième type de dopage (108), afin de diviser la couche de semiconducteur d'un deuxième type de dopage (108) en une pluralité de mésas de DEL (108-1, 108-2, 108-3, 108-4), où chaque mésa de DEL est isolée électriquement par le matériau implanté par ions ;
la réalisation d'une première opération de gravure pour retirer au moins une portion du matériau implanté par ions, une portion de la couche de MQW (110), une portion de la couche de semiconducteur d'un premier type de dopage (106) et une portion d'une couche de liaison (104) afin d'exposer une pluralité de contacts (120) d'un circuit d'excitation formé dans le premier substrat (102) ;
la formation d'une couche de passivation (112) sur la couche de semiconducteur d'un deuxième type de dopage (108) ;
la formation d'une première ouverture (124) sur la couche de passivation (112) exposant une portion de la couche de semiconducteur d'un deuxième type de dopage (108) et d'une deuxième ouverture (122) sur la couche de passivation (112) exposant le contact (120) ; et
la formation d'une couche d'électrode (114) sur la couche de passivation (112) recouvrant la première ouverture (124) et la deuxième ouverture (122),
où chaque contact (120) est situé au niveau d'un écartement de mésas de DEL (108-1, 108-2, 108-3, 108-4) adjacentes, et la couche d'électrode (114) connecte électriquement la couche de semiconducteur d'un deuxième type de dopage (108) et le contact (120) par l'intermédiaire de la première ouverture (124) et de la deuxième ouverture (122) sur chaque contact (120), et
la pluralité de mésas de DEL (108-1, 108-2, 108-3, 108-4) comprend une première mésa de DEL et une deuxième mésa de DEL adjacente à la première mésa de DEL, et
la couche de MQW (110), la couche de semiconducteur d'un premier type de dopage (106) et la couche de liaison (104) sous la première mésa de DEL s'étendent horizontalement par rapport à la couche de MQW (110), à la couche de semiconducteur d'un premier type de dopage (106) et à la couche de liaison (104) sous la deuxième mésa de DEL, et
la pluralité de mésas de DEL (108-1, 108-2, 108-3, 108-4) correspond à une pluralité d'unités de DEL (118-1, 118-2, 118-3, 118-4), respectivement, et chaque unité de DEL (118-1, 118-2, 118-3, 118-4) est excitée individuellement par un contact (120) correspondant du circuit d'excitation.

6. Le procédé de la revendication 5, où l'opération d'implantation est réalisée avec une énergie d'implantation comprise entre environ 10 keV et environ 300 keV.

7. Le procédé de la revendication 5 ou de la revendication 6, où la formation de la couche de semiconducteur sur le premier substrat (102) comprend :
la formation du circuit d'excitation dans le premier substrat (102) ;
la formation de la couche de semiconducteur sur un deuxième substrat (126) ;
la liaison de la couche de semiconducteur sur le premier substrat (102) par l'intermédiaire de la couche de liaison (104) ; et
le retrait du deuxième substrat (126).
